# EUROPEAN PATENT APPLICATION

(11) **EP 2 695 968 A1**
(43) Date of publication of application: **12.02.2014**
(21) Application number: 13177097.6
(22) Date of filing: 18.07.2013
(51) Int. Cl.: C23C 14/24, C23C 14/52

(54) **Deposition apparatus and method of measuring the deposition material in it**

(30) Priority: 09.08.2012 KR 20120087362
(71) Applicant: Samsung Display Co., Ltd., Yongin-City, Gyeonggi-Do, 446-711 (KR)
(72) Inventor: Kim, Younwoo, Gyeonggido (KR)
(74) Representative: Walaski, Jan Filip

(57) **Abstract**

A deposition apparatus includes a process chamber including an observing window (10), a crucible (200) disposed in the process chamber to overlap with the observing window (10) in a first direction, a disc (300) disposed between the observing window (10) and the crucible (200) to overlap with the observing window (10) in the first direction and rotated with respect to the first direction, a rotation unit coupled to the process chamber and the disc to rotate the disc, a deposition preventing plate disposed between the disc and the crucible and provided with an opening formed therethrough and overlapped with the observing window in the first direction, and a measuring sensor (500) disposed outside the process chamber to overlap with the observing window, the disc, and the crucible in the first direction. The measuring sensor (500) senses a distance between the deposition material and the measuring sensor to measure a residual amount of the deposition material.

## Description

The present disclosure relates to a deposition apparatus capable of measuring a residual amount of a deposition material on the basis of a distance between a measuring sensor and the deposition material and a method of measuring the residual amount of the deposition material using the deposition apparatus.

In general, a deposition apparatus is used to manufacture various devices, e.g., a display device. The deposition apparatus includes a process chamber and a crucible disposed in the process chamber to accommodate a deposition material. The deposition material vaporized from the crucible is deposited on a substrate placed above the crucible.

In the case that the deposition material is deposited on the substrate using the deposition apparatus, it is required to measure a residual amount of the deposition material in the crucible to find out a timing of replenishing the crucible with the deposition material.

To this end, the deposition apparatus includes a crystal sensor installed inside the process chamber so as to measure the residual amount of the deposition material in the crucible. The crystal sensor senses a variation of the number of vibrations according to a thickness of the deposition material adhered thereto.

However, the direction and position of the crystal sensor are changed while the crystal sensor is maintained when the substrate is replaced, and as a result, it is difficult to precisely measure the residual amount of the deposition material in the crucible.
The present invention may provide a deposition apparatus capable of measuring a residual amount of a deposition material.

The present invention may provide a method of measuring the residual amount of the deposition material in the deposition apparatus.

One or more embodiments of the present invention may provide a deposition apparatus including a process chamber, a crucible, a disc, a rotation unit, a deposition preventing plate, and a measuring sensor.

The process chamber may include an observing window disposed at a portion of an upper wall thereof.

The crucible may be disposed on a lower wall of inside of the process chamber to overlap with the observing window in a first direction and accommodates a deposition material therein.

The disc may be disposed between the observing window and the crucible to overlap with the observing window in the first direction and rotated with respect to the first direction. In some embodiments, the disc may have a circular shape when viewed in the first direction.

The rotation unit may be coupled to the process chamber and the disc to rotate the disc. In some embodiments, the rotation unit may include a rotation motor attached to an upper wall of the process chamber; and a shaft elongated in the first direction, rotationally coupled to the rotation motor and the disc. In some embodiments, the shaft is connected to a center of the disc. In some embodiments, the shaft may be disposed to be spaced apart from the observing window when viewed in the first direction.

The deposition preventing plate may be disposed between the disc and the crucible and provided with an opening formed therethrough. The opening may be overlapped with the observing window in the first direction.

The measuring sensor may be disposed outside the process chamber to overlap with the observing window, the disc, and the crucible in the first direction. The measuring sensor senses a distance between the deposition material and the measuring sensor to measure a residual amount of the deposition material. The measuring sensor may include a light emitting portion emitting a laser beam to the observing window along the first direction; and a light receiving portion receiving a portion of the laser beam.

The observing window and the disc may include quartz.

The observing window may be overlapped by a peripheral area of the disc when viewed in the first direction.

In some embodiments of the present invention, the deposition apparatus may include a transfer unit provided in the process chamber, wherein at least one substrates are mounted on the transfer unit, the transfer unit moves in a second direction perpendicular to the first direction to pass through between the deposition preventing plate and the crucible, and the deposition preventing plate and the crucible are disposed to be overlapped with each other, and the deposition material is deposited on the substrate.

Embodiments of the inventive concept provide a method of measuring a residual amount of a deposition material may includes preparing a deposition apparatus comprising a process chamber having an observing window; a crucible accommodating a deposition material; a disc; a rotation unit coupled to the disc; and a measuring sensor disposed outside of the process chamber to overlap with the observing window, the disc, and the crucible in a first direction; preparing a first substrate and a second substrate spaced apart from the first substrate in a second (or horizontal) direction perpendicular to the first direction by a predetermined distance; passing the first substrate above the crucible; depositing the deposition material on the first substrate; measuring the residual amount of the deposition material after the first substrate passes away from the crucible; passing the second substrate above the crucible; depositing the deposition material on the second substrate; and measuring the residual amount of the deposition material after the second substrate passes away from the crucible.

The measuring of the residual amount of the deposition material may include sensing a distance between the measuring sensor and the deposition material in the crucible to measure the residual amount of the deposition material. A laser beam emitted from the measuring sensor is incident to the deposition material; and the portion of the laser beam reflected from the deposition material is incident to the measuring sensor after passing through the disc and the observing window.

According to the above, the deposition apparatus may measure the residual amount of the deposition material in real time using the measuring sensor that emits the laser beam.

In addition, although the residual amount of the deposition material is measured, the deposition process does not need to be stop, thereby improving process yield in the deposition process.

A more complete appreciation of the present invention, and many of the attendant advantages thereof, will be readily apparent as the present invention becomes better understood by reference to the following detailed description when considered in conjunction with the accompanying drawings in which like reference symbols indicate the same or similar components wherein:
FIG. 1 is a cross-sectional view showing a deposition apparatus according to an embodiment of the present invention.
FIG. 2 is a plan view showing an observing window and a disc shown in FIG. 1, which are viewed in a first direction.
FIG. 3 is a block diagram showing a measuring sensor shown in FIG. 1.
FIG. 4 is a perspective view showing an observing window, a crucible, a disc, a measuring sensor, and a deposition preventing plate shown in FIG. 1.

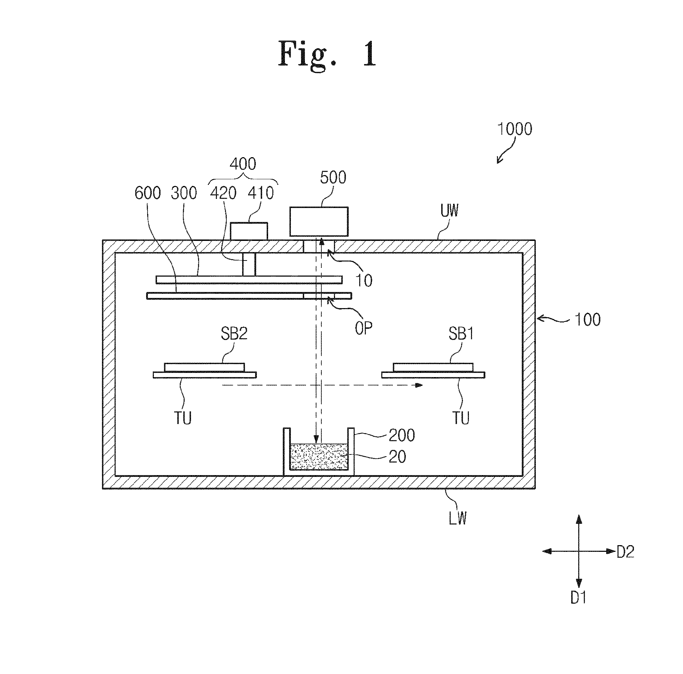

Referring to FIG. 1, the deposition apparatus 1000 includes a process chamber 100, a crucible 200, a disc 300, a rotation unit 400, and a measuring sensor 500.

The process chamber 100 is surrounded by walls with a predetermined thickness to provide a sealed space therein. The process chamber 100 can have various shapes, such as a dome shape, a hexahedral shape, etc. In the present exemplary embodiment, the process chamber 100 having the hexahedral shape will be described in detail.

Although not shown in FIG. 1, a vacuum pump may be attached with a wall of the process chamber 100 to maintain a vacuum state of the space in the process chamber 100.

The process chamber 100 includes an observing window 10 formed through a portion of an upper wall UW, also referred to as a ceiling, thereof as shown in FIG. 1.

The observing window 10 is formed of a quartz glass, but the observing window 10 should not be limited to the quartz glass. That is, various materials that transmit a laser beam may be used to form the observing window 10.

The crucible 200 is disposed on a lower wall LW, also referred to as the floor or base, inside the process chamber 100 and accommodates a deposition material 20 therein. The crucible 200 is used to vaporize the deposition material.

The deposition material 20 is deposited on substrates SB1 and SB2 loaded in the process chamber 100. The deposition material 20 may be aluminum, but is not limited to aluminum.

The crucible 200 includes a heating unit (not shown). The heating unit heats the crucible 200 to a temperature sufficient to vaporize the deposition material 20.

The crucible 200 is located at a position overlapped with the observing window 10 in a first direction D1, e.g., a vertical direction. Accordingly, the laser beam passing through the observing window 10 along the first direction D1 from the outside of the process chamber 100 reaches the deposition material 20 accommodated in the crucible 200. In other words, the crucible is aligned with the observation window to the extent required for the laser beam to irradiate the deposition material.

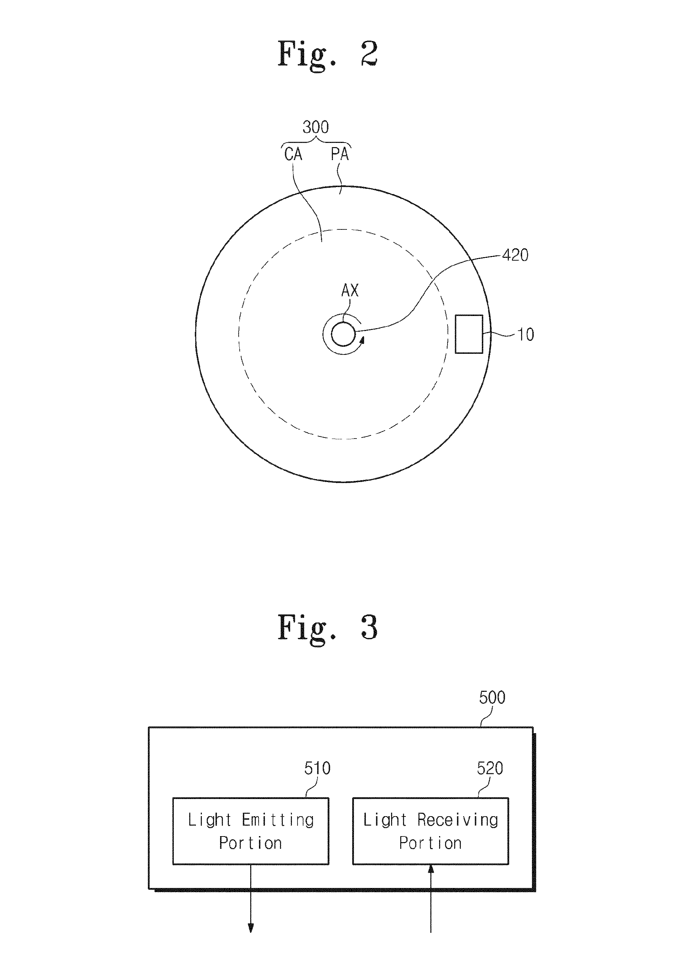

FIG. 2 is a plan view showing the observing window 10 and the disc 300 shown in FIG. 1 in the first direction D1.

Referring to FIGS. 1 and 2, the disc 300 is disposed between the observing window 10 and the crucible 200 and located at a position overlapped with the observing window 10 and the crucible 200 in the first direction D1.

When viewed in the first direction D1, the disc 300 has a circular shape.

The disc 300 includes a center area CA and a peripheral area PA surrounding the center area CA when viewed in the first direction D1.

In addition, when viewed in the first direction D1, the observing window 10 is located at a position overlapped with the peripheral area PA of the disc 300. It is preferred that the overlapped position between the observing window 10 and the disc 300 is closer to the peripheral area PA of the disc 300 when viewed in the first direction D1, but the observing window 10 is required to be located at a position overlapped with at least the disc 300 in the first direction D1. The overlapping portion, for example, the peripheral area PA, comprises a material that transmits a laser beam, such as quartz. In other words, the peripheral area of the disc lies in the path of the laser beam between the observing window 10 and the crucible 200. The whole disc, including the peripheral area, may comprise quartz.

The disc 300 is rotated with respect to the first direction D1 as its rotation axis AX. When viewed in the first direction D1, the rotation axis AX is spaced apart from the observing window 10.

The disc 300 prevents the deposition material 20 from being vaporized and deposited on the observing window 10 so as to improve transmittance of the laser beam incident to and passing through the observing window 10. In addition, the peripheral area of the disc 300 is required to have high transmittance for the laser beam, which may be achieved by a deposition preventing plate that will be described later.

Referring to FIG. 1 again, the rotation unit 400 is coupled to the process chamber 100 and the disc 300 to rotate the disc 300.

The rotation unit 400 includes a rotation motor 410 and a shaft 420.

The rotation motor 410 is attached to an upper wall UW of the process chamber 100. The rotation motor 410 is connected to the shaft 420 to rotate the shaft 420.

The shaft 420 has a shape elongated in the first direction D1. A first end portion of the shaft 420 is rotationally coupled to the rotation motor 410 after passing through the upper wall UW of the process chamber 100 and a second end portion of the shaft 420 is coupled to the disc 300. Thus, when the shaft 420 is rotated by the rotation motor 410, the disc 300 is rotated.

The second end portion of the shaft 420 is connected to a center of the disc 300. When viewed in the first direction D1, the shaft 420 is located to be spaced apart from the observing window 10.

FIG. 3 is a block diagram showing a measuring sensor shown in FIG. 1.

Referring to FIGS. 1 and 3, the measuring sensor 500 is disposed outside the process chamber 100 and located at a position overlapped with the observing window 10, the crucible 200, and the disc 300 in the first direction D1. In FIG. 1, the measuring sensor 500 is disposed on the upper wall UW, or ceiling, of the process chamber 100 to correspond to the observing window 10.

The measuring sensor 500 senses a distance between the deposition material 20 in the crucible 20 and the measuring sensor 500.

The measuring sensor 500 includes a light emitting portion 510 and a light receiving portion 520.

The light emitting portion 510 is disposed outside the process chamber 100 and emits the laser beam to the observing window 10 along the first direction D1. The laser beam emitted from the light emitting portion 510 reaches the surface of the deposition material 20 accommodated in the crucible 200 after passing through the observing window 10 and the disc 300. A portion of the laser beam emitted from the light emitting portion 510 is reflected by the surface of the deposition material 20 and the reflected laser beam reaches the measuring sensor 500 after passing through the disc 300 and the observing window 10.

The light receiving portion 520 receives the reflected laser beam to sense the distance between the measuring sensor 500 and the deposition material 20.

The measuring sensor 500 measures a residual amount of the deposition material 20 on the basis of the sensed distance. Although not shown in the figures, the measuring sensor 500 includes a look-up table in which data represents a relation between the amount of the deposition material 20 and the distance from the measuring sensor 500 to the deposition material 20. Thus, the measuring sensor 500 reads out the data of the amount of the deposition material 20. The data corresponds to the sensed distance from the measuring sensor 500 and to the deposition material 20, so that the residual amount of the deposition material 20 may be observed.

The deposition apparatus 1000 may further include a deposition preventing plate 600.

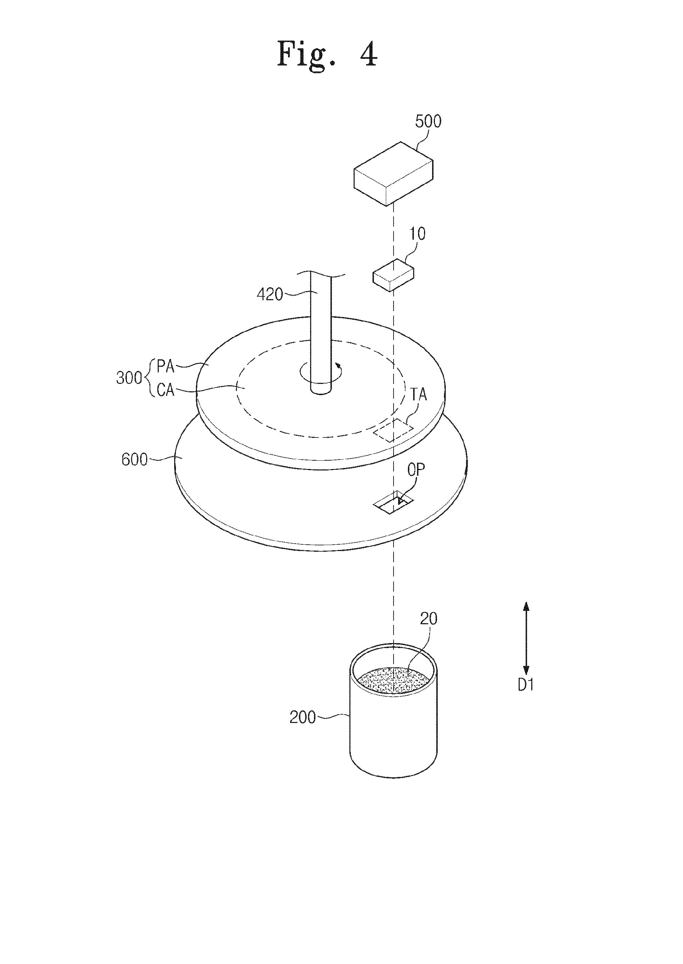

FIG. 4 is a perspective view showing the observing window 10, the crucible 200, the disc 300, the measuring sensor 500, and the deposition preventing plate 600 shown in FIG. 1.

Referring to FIGS. 1 and 4, the deposition preventing plate 600 is disposed between the disc 300 and the crucible 200 in the first direction D1.

The deposition preventing plate 600 is provided with an opening OP formed therethrough at a position to overlap, or aligned, with the observing window 10 in the first direction D1. In addition, the opening OP is also located at a position overlapped with the peripheral area PA of the disc 300 and the crucible 200 in the first direction D1. Therefore, the laser beam emitted from the measuring sensor 500 passes through the opening OP.

The deposition preventing plate 600 prevents the deposition material 20 vaporized from the crucible 200 from being deposited on the lower surface of the center area CA of the disc 300. The deposition material 20 is deposited on the lower surface of the peripheral area PA of the disc 300. In this case, since the disc 300 is rotated with respect to the shaft 420 as its rotation axis, the deposition material 20 is uniformly deposited on the lower surface of the peripheral area PA of the disc 300. Accordingly, a very small amount of the deposition material 20 is deposited in an area TA of the lower surface of the peripheral area PA of the disc 300 at a specific moment. The area TA is overlapped with the observing window 10 in the first direction D1. Therefore, the amount of the deposition material 20 deposited on the lower surface of the peripheral area PA of the disc 300 does not exert any influence on the transmission of the laser beam emitted from the measuring sensor 500 and passing through the disc 300.

The shape of the deposition preventing plate 600 should not be limited to a specific shape as long as the deposition preventing plate 600 covers the disc 300 when viewed from below. In FIG. 4, the deposition preventing plate 600 has a circular shape with a diameter greater than that of the disc 300.

Although not shown in figures, the deposition preventing plate 600 may be connected to the process chamber 100 and fixed to the process chamber 100.

Referring back to FIG. 1, the substrates SB1 and SB2 are loaded in the process chamber 100. FIG. 1 shows the first substrate SB1 and the second substrate SB2, on which the deposition material 20 is sequentially deposited.

The first substrate SB1 and the second substrate SB2 move in a second direction D2 which is substantially perpendicular to the first direction D1 to allow the first and second substrates SB1 and SB2 to pass between the crucible 200 and the deposition preventing plate 600.

Although not shown in figures, the first and second substrates SB1 and SB2 are mounted on a transfer unit TU provided in the process chamber 100 and move in the second direction D2 by the transfer unit TU. For example, the transfer unit TU may be a conveyor belt. The first substrate SB1 and the second substrate SB2 are spaced apart from each other in the second direction D2 while moving in the second direction D2.

According to the deposition apparatus 1000, the portion of the laser beam emitted from the measuring sensor 500 and reflected by the surface of the deposition material 20 crosses between the first substrate SB1 and the second substrate SB2 along the first direction D1 so as to be incident to the measuring sensor 500.

The deposition apparatus 1000 according to the present exemplary embodiment may measure the residual amount of the deposition material 20 in real time by using the measuring sensor 500. In addition, since the deposition material 20 is prevented from being deposited on the observing window 10 by the disc 300 and prevented from being deposited on the lower surface of the center area CA of the disc 300 by the deposition preventing plate 600, the laser beam emitted from the measuring sensor 500 may pass through the observing window 10, the peripheral area PA of the disc 300, and the opening OP of the deposition preventing plate 600.

Hereinafter, a method of measuring the residual amount of the deposition material 20 will be described in detail with reference to FIG. 1.

The first substrate SB1 and the second substrate SB2 are loaded in the process chamber 100 such that the first substrate SB1 and the second substrate SB2 are spaced apart from each other by a predetermined distance in the second direction D2.

When the first substrate SB1 passes above the crucible 200 along the second direction D2, the deposition material 20 is deposited on the first substrate SB1.

After the first substrate SB1 passes above the crucible 200 along the second direction D2, the measuring sensor 500 measures the residual amount of the deposition material 20 before the second substrate SB2 passes above the crucible 200 along the second direction D2.

In this case, the measuring sensor 500, the observing window 10, the disc 300, the opening OP, and the crucible 200 are sequentially arranged downward from the top of the process chamber 100 and overlapped with each other when viewed in the first direction D1. The residual amount of the deposition material 20 is measured on the basis of the distance between the measuring sensor 500 and the deposition material 20 in the crucible 200.

To this end, the laser beam emitted from the light emitting portion 510 of the measuring sensor 500 is incident to the deposition material 20, and the portion of the laser beam reflected by the surface of the deposition material 20 is incident to the light receiving portion 520 of the measuring sensor 500 after sequentially passing through the opening OP, the disc 300, and the observing window 10.

After measuring the residual amount of the deposition material 20, the next deposition process follows. Then, when the second substrate SB2 passes above the crucible 200 along the second direction D2, the deposition material 20 is deposited on the second substrate SB2.

According to the method of measuring the residual amount of the deposition material 20, the laser beam emitted from the measuring sensor 500 is provided to the deposition material 20 after passing through a space between the first substrate SB1 and the second substrate SB2 and the portion of the laser beam reflected by the deposition material 20 is incident to the measuring sensor 500 after passing through the space between the first substrate SB1 and the second substrate SB2. Thus, although the residual amount of the deposition material 20 is measured, the deposition process does not need to be stopped, thereby improving process yield in the deposition process. Although the exemplary embodiments of the present invention have been described, it is understood that the present invention should not be limited to these exemplary embodiments but various changes and modifications can be made by one ordinary skilled in the art within the scope of the present invention as hereinafter claimed.

## Claims

1. A deposition apparatus (1000) comprising:
a process chamber (100) comprising an observing window (10) disposed in an upper wall thereof;
a crucible (200) disposed inside the process chamber and aligned with the observing window for accommodating a deposition material (20);
a rotatable disc (300) disposed between the observing window and the crucible;
a rotation unit arranged to rotate the disc; and
a measuring sensor (500) for measuring a residual amount of deposition material in the crucible, the measuring sensor being disposed outside the process chamber and aligned with the observing window (10) and the crucible, the measuring sensor being arranged to sense the distance to the deposition material.

2. The deposition apparatus of claim 1, wherein the measuring sensor comprises:
a light emitting portion (510) for emitting a laser beam towards the crucible;
and
a light receiving portion (520) for receiving a portion of the laser beam reflected from the deposition material in the crucible.

3. The deposition apparatus of claim 1 or 2, further comprising a deposition preventing plate (600) disposed between the disc and the crucible, the deposition preventing plate having an opening formed therethrough, wherein the opening is aligned with the observing window.

4. The deposition apparatus of any one of the preceding claims, wherein the path between the observing window and the crucible passes through a peripheral area of the disc.

5. The deposition apparatus of any one of the preceding claims, further comprising a transfer unit provided in the process chamber, wherein at least one substrate is mounted on the transfer unit, the transfer unit being arranged to move in a direction perpendicular to the path between the observing window and the crucible, wherein the deposition material is arranged to be deposited on the substrate.

6. The deposition apparatus of any one of the preceding claims, wherein the observing window and a peripheral area of the disc comprise quartz.

7. The deposition apparatus of any one of the preceding claims, wherein the disc is circular.

8. The deposition apparatus of any one of the preceding claims, wherein the rotation unit comprises:
a rotation motor (410) attached to an upper part of the process chamber; and
a shaft (420) coupled to the rotation motor and the disc.

9. The deposition apparatus of claim 8, wherein the shaft is connected to a center of the disc.

10. The deposition apparatus of claim 9, wherein the shaft is offset from the observing window.

11. A method of measuring a residual amount of deposition material using a deposition apparatus according to any one of the preceding claims, comprising:
preparing a first substrate and a second substrate spaced apart from the first substrate;
passing the first substrate above the crucible;
depositing the deposition material on the first substrate;
measuring the residual amount of the deposition material after the first substrate passes away from the crucible;
passing the second substrate above the crucible;
depositing the deposition material on the second substrate; and
measuring the residual amount of the deposition material after the second substrate passes away from the crucible.

12. The method of claim 11, wherein the measuring of the residual amount of the deposition material comprising
sensing a distance between the measuring sensor and the deposition material in the crucible to measure the residual amount of the deposition material.

13. The method of claim 12, wherein a laser beam emitted from the measuring sensor is incident to the deposition material and the portion of the laser beam reflected from the deposition material is incident to the measuring sensor after passing through the disc and the observing window.
